# EUROPEAN PATENT APPLICATION

(11) **EP 4 793 992 A1**
(43) Date of publication of application: **19.08.2026**
(21) Application number: 24877280.8
(22) Date of filing: 11.10.2024
(51) Int. Cl.: H01L 23/12, H01L 23/15, H05K 1/02, H05K 1/11, H05K 3/42

(54) **THROUGH ELECTRODE SUBSTRATE, SEMICONDUCTOR PACKAGE, AND MANUFACTURING METHOD THEREOF**

(30) Priority: 12.10.2023 JP 2023176537
(71) Applicant: Dai Nippon Printing Co., Ltd., Tokyo 162-8001 (JP)
(72) Inventor: KURAMOCHI, Satoru, Tokyo 162-8001 (JP)
(74) Representative: Müller-Boré & Partner Patentanwälte PartG mbB
(86) International application number: PCT/JP2024/036453
(87) International publication number: WO 2025/079686

(57) **Abstract**

A through electrode substrate includes: a glass substrate including a first surface, a second surface located on a side opposite to the first surface, and a first through hole and a second through hole extending from the first surface to the second surface; a through electrode located in the first through hole; a resin member located in the second through hole; and a wiring layer located between the glass substrate and a semiconductor element. The first through hole includes a first opening that is open at the first surface of the glass substrate and a second opening that is open at the second surface of the glass substrate. The second through hole includes a third opening that is open at the first surface of the glass substrate and a fourth opening that is open at the second surface of the glass substrate. The through electrode closes the first through hole between the first opening and the second opening. The resin member continuously extends in the second through hole from the third opening to the fourth opening.

## Description

### Technical Field

Embodiments of the present disclosure relate to a through electrode substrate, a semiconductor package, and methods for manufacturing the same.

### Background Art

Through electrode substrates are used in various applications. A through electrode substrate is a member including: a substrate including a first surface, a second surface, and a through hole; and a through electrode located in the through hole. The through electrode substrate is used, for example, as an interposer. The interposer is a member interposed between two electrical components. The through electrode substrate is interposed, for example, between a semiconductor element and a mounting substrate. The through electrode substrate may include a wiring layer. The wiring layer serves, for example, to relocate a pad or a terminal of the semiconductor element to another location. Such a wiring layer is also referred to as a redistribution layer. The wiring layer is disposed on the substrate. In addition, a glass substrate is sometimes used as the substrate of the through electrode substrate.

### Citation List

### Patent Literature

PTL 1: Japanese Unexamined Patent Application Publication No. 2023-75206

### Summary of Invention

### Technical Problem

The wiring layer may contain a gas component. The gas component contained in the wiring layer needs to be discharged to the outside. However, when a glass substrate is used as the substrate of the through electrode substrate, in a semiconductor package in which a semiconductor element is mounted on the through electrode substrate, the wiring layer is disposed between the glass substrate and the semiconductor element. In this case, because the glass substrate and the semiconductor element are less likely to allow gas to permeate therethrough, the gas component contained in the wiring layer is not easily discharged to the outside. Hence, the gas component contained in the wiring layer cannot be sufficiently discharged to the outside, and the gas component may be retained in the wiring layer. Due to the retained gas component, the wiring layer may expand, and the wiring layer may peel from the glass substrate. As a result, the reliability of the through electrode substrate may decrease.

An object of the embodiments of the present disclosure is to provide a through electrode substrate and a semiconductor package that can effectively solve such problems, and methods for manufacturing the same.

### Solution to Problem

Embodiments of the present disclosure relate to [1] to [21] below.
[1] A through electrode substrate on which a semiconductor element is to be mounted, comprising:
   a glass substrate including a first surface, a second surface located on a side opposite to the first surface, and a first through hole and a second through hole extending from the first surface to the second surface;
   a through electrode located in the first through hole;
   a resin member located in the second through hole; and
   a wiring layer located between the glass substrate and the semiconductor element, wherein
   the first through hole includes a first opening that is open at the first surface of the glass substrate and a second opening that is open at the second surface of the glass substrate,
   the second through hole includes a third opening that is open at the first surface of the glass substrate and a fourth opening that is open at the second surface of the glass substrate,
   the through electrode closes the first through hole between the first opening and the second opening, and
   the resin member continuously extends in the second through hole from the third opening to the fourth opening.
[2] The through electrode substrate according to [1], wherein
   the first through hole includes a first minimum portion located between the first opening and the second opening and having a minimum hole diameter of the first through hole, and
   the through electrode does not close the first through hole at the first opening or the second opening and closes the first through hole at least at the first minimum portion.
[3] The through electrode substrate according to [1], wherein the through electrode fills the first through hole.
[4] The through electrode substrate according to any one of [1] to [3], wherein the resin member fills the second through hole.
[5] The through electrode substrate according to any one of [1] to [4], wherein the second through hole has the same shape as the first through hole.
[6] The through electrode substrate according to any one of [1] to [5], wherein the second through hole is located in a region overlapping the semiconductor element in plan view.
[7] The through electrode substrate according to [6], wherein the second through hole is located in a region located 3 mm inside an outer peripheral edge of the semiconductor element in plan view.
[8] The through electrode substrate according to [6] or [7], wherein a plurality of the second through holes are arranged at equal intervals in the region overlapping the semiconductor element in plan view.
[9] The through electrode substrate according to any one of [6] to [8], wherein 10 or more and 250 or less second through holes are located per 100 mm² in the region overlapping the semiconductor element in plan view.
[10] The through electrode substrate according to any one of [1] to [9], wherein a hole diameter of the second through hole at the third opening is 50 µm or more and 100 µm or less.
[11] The through electrode substrate according to any one of [1] to [10], wherein a thickness of the glass substrate is 100 µm or more and 1200 µm or less.
[12] The through electrode substrate according to any one of [1] to [11], wherein a planar area of the semiconductor element is 100 mm² or more.
[13] A through electrode substrate on which a semiconductor element is to be mounted, comprising:
   a glass substrate including a first surface, a second surface located on a side opposite to the first surface, and a first through hole and a second through hole extending from the first surface to the second surface;
   through electrodes respectively located in the first through hole and the second through hole;
   a resin member located at least in the second through hole; and
   a wiring layer located between the glass substrate and the semiconductor element, wherein
   the first through hole includes a first opening that is open at the first surface of the glass substrate, a second opening that is open at the second surface of the glass substrate, and a first wall surface located between the first opening and the second opening,
   the second through hole includes a third opening that is open at the first surface of the glass substrate, a fourth opening that is open at the second surface of the glass substrate, and a second wall surface located between the third opening and the fourth opening,
   the through electrode located in the first through hole extends along the first wall surface from the first opening to the second opening,
   the through electrode located in the second through hole extends along the second wall surface from the third opening to the fourth opening,
   the resin member is located inside the through electrode in the second through hole and continuously extends from the third opening to the fourth opening,
   a hole diameter of the second through hole at the third opening is 50 µm or more and 100 µm or less, and
   a thickness of the through electrode located in the second through hole is 5 µm or more and 25 µm or less.
[14] The through electrode substrate according to [13], wherein the second through hole is located in a region overlapping the semiconductor element in plan view.
[15] The through electrode substrate according to [14], wherein 27 or more and 2500 or less second through holes are located per 100 mm² in the region overlapping the semiconductor element in plan view.
[16] A semiconductor package comprising:
   the through electrode substrate according to any one of [1] to [15]; and
   a semiconductor element mounted on the through electrode substrate.
[17] A through electrode substrate comprising:
   a glass substrate including a first surface, a second surface located on a side opposite to the first surface, and a first through hole and a second through hole extending from the first surface to the second surface;
   a through electrode located in the first through hole; and
   a resin member located in the second through hole, wherein
   the first through hole includes a first opening that is open at the first surface of the glass substrate and a second opening that is open at the second surface of the glass substrate,
   the second through hole includes a third opening that is open at the first surface of the glass substrate and a fourth opening that is open at the second surface of the glass substrate,
   the through electrode closes the first through hole between the first opening and the second opening, and
   the resin member continuously extends in the second through hole from the third opening to the fourth opening.
[18] A through electrode substrate comprising:
   a glass substrate including a first surface, a second surface located on a side opposite to the first surface, and a first through hole and a second through hole extending from the first surface to the second surface;
   through electrodes respectively located in the first through hole and the second through hole; and
   a resin member located at least in the second through hole, wherein
   the first through hole includes a first opening that is open at the first surface of the glass substrate, a second opening that is open at the second surface of the glass substrate, and a first wall surface located between the first opening and the second opening,
   the second through hole includes a third opening that is open at the first surface of the glass substrate, a fourth opening that is open at the second surface of the glass substrate, and a second wall surface located between the third opening and the fourth opening,
   the through electrode located in the first through hole extends along the first wall surface from the first opening to the second opening,
   the through electrode located in the second through hole extends along the second wall surface from the third opening to the fourth opening,
   the resin member is located inside the through electrode in the second through hole and continuously extends from the third opening to the fourth opening,
   a hole diameter of the second through hole at the third opening is 50 µm or more and 100 µm or less, and
   a thickness of the through electrode located in the second through hole is 5 µm or more and 25 µm or less.
[19] A method for manufacturing a through electrode substrate on which a semiconductor element is to be mounted, the method comprising:
   a step of preparing a glass substrate including a first surface, a second surface located on a side opposite to the first surface, and a first through hole and a second through hole extending from the first surface to the second surface;
   a step of forming a through electrode in the first through hole;
   a step of forming a resin member in the second through hole; and
   a step of forming a wiring layer on the first surface of the glass substrate, wherein
   the first through hole includes a first opening that is open at the first surface of the glass substrate and a second opening that is open at the second surface of the glass substrate,
   the second through hole includes a third opening that is open at the first surface of the glass substrate and a fourth opening that is open at the second surface of the glass substrate,
   the through electrode closes the first through hole between the first opening and the second opening, and
   the resin member continuously extends in the second through hole from the third opening to the fourth opening.
[20] A method for manufacturing a through electrode substrate on which a semiconductor element is to be mounted, the method comprising:
   a step of preparing a glass substrate including a first surface, a second surface located on a side opposite to the first surface, and a first through hole and a second through hole extending from the first surface to the second surface;
   a step of forming through electrodes respectively in the first through hole and the second through hole;
   a step of forming a resin member at least in the second through hole; and
   a step of forming a wiring layer on the first surface of the glass substrate, wherein
   the first through hole includes a first opening that is open at the first surface of the glass substrate, a second opening that is open at the second surface of the glass substrate, and a first wall surface located between the first opening and the second opening,
   the second through hole includes a third opening that is open at the first surface of the glass substrate, a fourth opening that is open at the second surface of the glass substrate, and a second wall surface located between the third opening and the fourth opening,
   the through electrode located in the first through hole extends along the first wall surface from the first opening to the second opening,
   the through electrode located in the second through hole extends along the second wall surface from the third opening to the fourth opening,
   the resin member is located inside the through electrode in the second through hole and continuously extends from the third opening to the fourth opening,
   a hole diameter of the second through hole at the third opening is 50 µm or more and 100 µm or less, and
   a thickness of the through electrode located in the second through hole is 5 µm or more and 25 µm or less.
[21] A method for manufacturing a semiconductor package, the method comprising:
   a step of manufacturing a through electrode substrate using the method for manufacturing a through electrode substrate according to [19] or [20]; and
   a step of mounting a semiconductor element on the through electrode substrate.

### Advantageous Effects of Invention

According to the embodiments of the present disclosure, it is possible to increase the reliability of a through electrode substrate including a glass substrate.

### Brief Description of Drawings

[Fig. 1] Fig. 1 is a cross-sectional view illustrating a semiconductor package according to one embodiment.
[Fig. 2] Fig. 2 is an enlarged cross-sectional view illustrating a first through hole in Fig. 1.
[Fig. 3] Fig. 3 is an enlarged cross-sectional view illustrating a second through hole in Fig. 1.
[Fig. 4] Fig. 4 is a plan view of the semiconductor package in Fig. 1.
[Fig. 5] Fig. 5 is a cross-sectional view for explaining a glass substrate preparation step in a method for manufacturing a through electrode substrate according to one embodiment.
[Fig. 6] Fig. 6 is a cross-sectional view for explaining a through electrode forming step in the method for manufacturing the through electrode substrate according to one embodiment.
[Fig. 7] Fig. 7 is a cross-sectional view for explaining a resin member forming step in the method for manufacturing the through electrode substrate according to one embodiment.
[Fig. 8] Fig. 8 is a cross-sectional view for explaining a wiring layer forming step in the method for manufacturing the through electrode substrate according to one embodiment.
[Fig. 9] Fig. 9 is a cross-sectional view for explaining a semiconductor element mounting step in a method for manufacturing a semiconductor package according to one embodiment.
[Fig. 10] Fig. 10 is a cross-sectional view illustrating a modification of the first through hole in Fig. 2.
[Fig. 11] Fig. 11 is a cross-sectional view illustrating a modification of the second through hole in Fig. 3.
[Fig. 12] Fig. 12 is a cross-sectional view illustrating another modification of the second through hole in Fig. 11.
[Fig. 13] Fig. 13 is a cross-sectional view illustrating another modification of the first through hole in Fig. 2.
[Fig. 14] Fig. 14 is a cross-sectional view illustrating another modification of the second through hole in Fig. 3.
[Fig. 15] Fig. 15 is a cross-sectional view illustrating another modification of the first through hole in Fig. 13.
[Fig. 16] Fig. 16 is a cross-sectional view illustrating another modification of the second through hole in Fig. 14.
[Fig. 17] Fig. 17 is a diagram illustrating examples of products on which the semiconductor package is mounted.
[Fig. 18] Fig. 18 is a table illustrating evaluation results in a first example.
[Fig. 19] Fig. 19 is a table illustrating evaluation results in a second example.

### Description of Embodiments

Hereinbelow, a through electrode substrate, a semiconductor package, and methods for manufacturing the same will be described in detail with reference to the drawings. The embodiments described below are examples of embodiments of the present disclosure, and the present disclosure is not construed as being limited to these embodiments. In the present specification, terms such as "substrate", "base member", "sheet", and "film" are not distinguished from each other only on the basis of differences in terminology. For example, "substrate" is a concept including members that can also be referred to as sheets or films. A "surface" refers to a surface that coincides with a planar direction of a plate-shaped member when the plate-shaped member to be considered is viewed as a whole and macroscopically. A normal direction with respect to the plate-shaped member refers to a normal direction to the surface of the member. In the present specification, terms specifying shapes or geometric conditions and degrees thereof, such as "parallel" and "orthogonal", and values of length and angle are not limited to strict meanings and are interpreted to include ranges that can be expected to exhibit similar functions.

In the present specification, when a plurality of candidate upper limit values and a plurality of candidate lower limit values are presented for a parameter, a numerical range of the parameter may be defined by combining any one of the candidate upper limit values and any one of the candidate lower limit values. For example, consider a case where it is described that "Parameter B is, for example, A1 or more, may be A2 or more, and may be A3 or more. Parameter B is, for example, A4 or less, may be A5 or less, and may be A6 or less". In this case, the numerical range of Parameter B may be A1 or more and A4 or less, may be A1 or more and A5 or less, may be A1 or more and A6 or less, may be A2 or more and A4 or less, may be A2 or more and A5 or less, may be A2 or more and A6 or less, may be A3 or more and A4 or less, may be A3 or more and A5 or less, or may be A3 or more and A6 or less.

In the drawings referred to in this embodiment, the same reference numerals or similar reference numerals denote the same portions or portions having similar functions, and repeated description thereof may be omitted. In addition, dimensional ratios in the drawings may differ from actual ratios for convenience of explanation, and a part of the configuration may be omitted from the drawings.

### Semiconductor Package

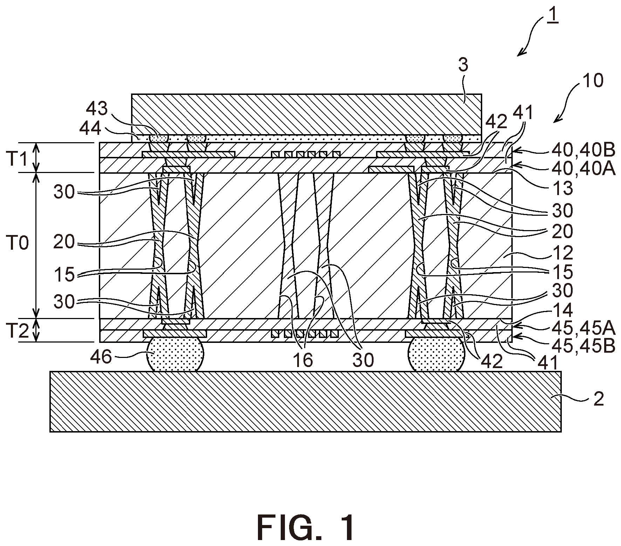

Fig. 1 is a cross-sectional view illustrating a semiconductor package 1 according to one embodiment. The semiconductor package 1 is a device mounted on a mounting substrate 2. The mounting substrate 2 is, for example, a BGA substrate or a motherboard. The semiconductor package 1 includes a through electrode substrate 10 and a semiconductor element 3. The semiconductor element 3 is, for example, a CPU, a GPU, an FPGA, a sensor, or a memory.

### Through Electrode Substrate

The through electrode substrate 10 is a substrate on which the semiconductor element 3 is to be mounted. The through electrode substrate 10 is electrically connected to the semiconductor element 3. The through electrode substrate 10 is located between the mounting substrate 2 and the semiconductor element 3. The through electrode substrate 10 electrically connects the mounting substrate 2 and the semiconductor element 3. The through electrode substrate 10 includes a glass substrate 12, a through electrode 20, and a resin member 30. The through electrode substrate 10 may include a wiring layer 40. Hereinbelow, components of the through electrode substrate 10 will be described.

### Glass Substrate

The glass substrate 12 has insulating properties. The glass substrate 12 is composed of a glass material. Examples of the glass material include alkali-free glass. Alkali-free glass is glass that does not contain alkali components such as sodium or potassium. Alkali-free glass contains, for example, boric acid instead of alkali components. In addition, the alkali-free glass contains, for example, alkaline earth metal oxides such as calcium oxide and barium oxide.

The thickness T0 of the glass substrate 12 is, for example, 100 µm or more, may be 200 µm or more, and may be 300 µm or more. The thickness T0 of the glass substrate 12 is, for example, 1200 µm or less, may be 800 µm or less, and may be 500 µm or less.

The glass substrate 12 includes a first surface 13, a second surface 14, a first through hole 15, and a second through hole 16. The first surface 13 is a surface facing the semiconductor element 3 side. The first surface 13 may be formed flat. The second surface 14 is a surface facing the mounting substrate 2 side. The second surface 14 is located on the side opposite to the first surface 13. The second surface 14 may be formed flat. The first through hole 15 and the second through hole 16 extend from the first surface 13 to the second surface 14. The glass substrate 12 may include a plurality of first through holes 15. The glass substrate 12 may include a plurality of second through holes 16.

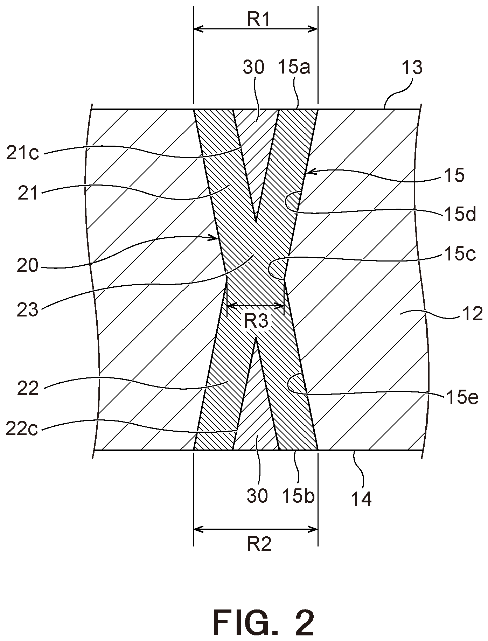

Fig. 2 is an enlarged cross-sectional view illustrating the first through hole 15 in Fig. 1. For simplification of the drawing, the dimensional ratio in Fig. 2 is different from the dimensional ratio in Fig. 1. The first through hole 15 includes a first opening 15a and a second opening 15b. The first opening 15a is an opening that is open at the first surface 13 of the glass substrate 12. The second opening 15b is an opening that is open at the second surface 14 of the glass substrate 12. The second opening 15b is located on the side opposite to the first opening 15a.

The hole diameter R1 at the first opening 15a of the first through hole 15 is, for example, 50 µm or more, may be 65 µm or more, and may be 75 µm or more. The hole diameter R1 is, for example, 100 µm or less, may be 90 µm or less, and may be 85 µm or less. The same applies to the hole diameter R2 at the second opening 15b of the first through hole 15. The hole diameter R2 may be equal to the hole diameter R1. The hole diameter R2 may be smaller than or larger than the hole diameter R1.

The first through hole 15 may include a first minimum portion 15c. The first minimum portion 15c is located between the first opening 15a and the second opening 15b. The first minimum portion 15c is a portion having a minimum hole diameter R3 of the first through hole 15. The hole diameter of the first through hole 15 may decrease from the first opening 15a toward the first minimum portion 15c. The hole diameter of the first through hole 15 may decrease from the second opening 15b toward the first minimum portion 15c.

The first through hole 15 may include a first wall surface 15d and a second wall surface 15e. The first wall surface 15d is a wall surface located between the first opening 15a and the first minimum portion 15c. The first wall surface 15d may extend straight from the first opening 15a to the first minimum portion 15c, or may extend in a curved manner. For example, the first wall surface 15d may be curved in a concave shape or a convex shape. The second wall surface 15e is a wall surface located between the second opening 15b and the first minimum portion 15c. The second wall surface 15e may extend straight from the second opening 15b to the first minimum portion 15c, or may extend in a curved manner. For example, the second wall surface 15e may be curved in a concave shape or a convex shape. The first wall surface 15d and the second wall surface 15e are connected to each other at the first minimum portion 15c.

The first minimum portion 15c may be located midway between the first surface 13 and the second surface 14 in the thickness direction of the glass substrate 12. The first minimum portion 15c may be located closer to the first surface 13 than to the second surface 14 in the thickness direction of the glass substrate 12. The first minimum portion 15c may be located closer to the second surface 14 than to the first surface 13 in the thickness direction of the glass substrate 12.

The hole diameter R3 at the first minimum portion 15c of the first through hole 15 is smaller than the hole diameter R1 at the first opening 15a of the first through hole 15. The hole diameter R3 at the first minimum portion 15c of the first through hole 15 is smaller than the hole diameter R2 at the second opening 15b of the first through hole 15. The hole diameter R3 at the first minimum portion 15c of the first through hole 15 is, for example, 20 µm or more, may be 35 µm or more, and may be 45 µm or more. The hole diameter R3 is, for example, 80 µm or less, may be 65 µm or less, and may be 55 µm or less.

The first opening 15a may have a circular contour in plan view. In this case, the hole diameter R1 means the diameter of the first opening 15a. The second opening 15b may have a circular contour in plan view. In this case, the hole diameter R2 means the diameter of the second opening 15b. The first minimum portion 15c may have a circular contour in plan view. In this case, the hole diameter R3 means the diameter of the first minimum portion 15c. In the present specification, "plan view" means observation of an object in a direction orthogonal to (a direction normal to) the first surface 13 or the second surface 14 of the glass substrate 12.

The first opening 15a may have a contour other than a circular contour in plan view. In this case, the hole diameter R1 is calculated from the diameter of a circle obtained by converting the first opening 15a into a circle having a planar area equal to that of the first opening 15a. The second opening 15b may have a contour other than a circular contour in plan view. In this case, the hole diameter R2 is calculated from the diameter of a circle obtained by converting the second opening 15b into a circle having a planar area equal to that of the second opening 15b. The first minimum portion 15c may have a contour other than a circular contour in plan view. In this case, the hole diameter R3 is calculated from the diameter of a circle obtained by converting the first minimum portion 15c into a circle having a planar area equal to that of the first minimum portion 15c. In the present specification, "planar area" means the area inside the contour of an object in plan view.

The first through hole 15 may be located in a region A1 that overlaps the semiconductor element 3 in plan view. The first through hole 15 does not need to be located in a region not overlapping the semiconductor element 3 in plan view.

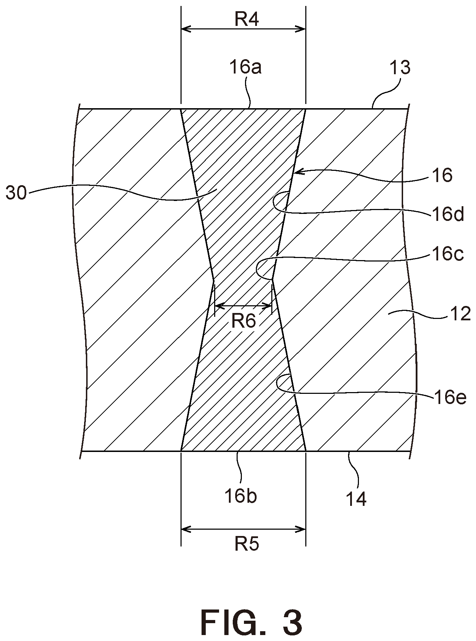

Fig. 3 is an enlarged cross-sectional view illustrating the second through hole 16 in Fig. 1. For simplification of the drawing, the dimensional ratio in Fig. 3 is different from the dimensional ratio in Fig. 1. The second through hole 16 may have the same shape as the first through hole 15. The second through hole 16 includes a third opening 16a and a fourth opening 16b. The third opening 16a is an opening that is open at the first surface 13 of the glass substrate 12. The fourth opening 16b is an opening that is open at the second surface 14 of the glass substrate 12. The fourth opening 16b is located on the side opposite to the third opening 16a.

The hole diameter R4 at the third opening 16a of the second through hole 16 may be equal to the hole diameter R1 at the first opening 15a of the first through hole 15. The hole diameter R5 at the fourth opening 16b of the second through hole 16 may also be equal to the hole diameter R2 at the second opening 15b of the first through hole 15. The hole diameter R4 at the third opening 16a of the second through hole 16 is, for example, 50 µm or more, may be 65 µm or more, and may be 75 µm or more. The hole diameter R4 is, for example, 100 µm or less, may be 90 µm or less, and may be 85 µm or less. The same applies to the hole diameter R5 at the fourth opening 16b of the second through hole 16. The hole diameter R5 may be equal to the hole diameter R4. The hole diameter R5 may be smaller than or larger than the hole diameter R4.

The hole diameter R4 at the third opening 16a of the second through hole 16 may be smaller than the hole diameter R1 at the first opening 15a of the first through hole 15. The hole diameter R5 at the fourth opening 16b of the second through hole 16 may also be smaller than the hole diameter R2 at the second opening 15b of the first through hole 15. In this case, the ratio of the hole diameter R4 to the hole diameter R1 is, for example, 0.2 or more, may be 0.3 or more, and may be 0.4 or more. The ratio of the hole diameter R4 to the hole diameter R1 is, for example, 0.7 or less, may be 0.6 or less, and may be 0.5 or less. The same applies to the ratio of the hole diameter R5 to the hole diameter R2.

The second through hole 16 may include a second minimum portion 16c. The second minimum portion 16c is located between the third opening 16a and the fourth opening 16b. The second minimum portion 16c is a portion having a minimum hole diameter R6 of the second through hole 16. The hole diameter of the second through hole 16 may decrease from the third opening 16a toward the second minimum portion 16c. The hole diameter of the second through hole 16 may decrease from the fourth opening 16b toward the second minimum portion 16c.

The second through hole 16 may include a third wall surface 16d and a fourth wall surface 16e. The third wall surface 16d is a wall surface located between the third opening 16a and the second minimum portion 16c. The third wall surface 16d may extend straight from the third opening 16a to the second minimum portion 16c, or may extend in a curved manner. For example, the third wall surface 16d may be curved in a concave shape or a convex shape. The fourth wall surface 16e is a wall surface located between the fourth opening 16b and the second minimum portion 16c. The fourth wall surface 16e may extend straight from the fourth opening 16b to the second minimum portion 16c, or may extend in a curved manner. For example, the fourth wall surface 16e may be curved in a concave shape or a convex shape. The third wall surface 16d and the fourth wall surface 16e are connected to each other at the second minimum portion 16c.

The second minimum portion 16c may be located midway between the first surface 13 and the second surface 14 in the thickness direction of the glass substrate 12. The second minimum portion 16c may be located closer to the first surface 13 than to the second surface 14 in the thickness direction of the glass substrate 12. The second minimum portion 16c may be located closer to the second surface 14 than to the first surface 13 in the thickness direction of the glass substrate 12.

The hole diameter R6 at the second minimum portion 16c of the second through hole 16 is smaller than the hole diameter R4 at the third opening 16a of the second through hole 16. The hole diameter R6 at the second minimum portion 16c of the second through hole 16 is smaller than the hole diameter R5 at the fourth opening 16b of the second through hole 16. The hole diameter R6 at the second minimum portion 16c of the second through hole 16 may be equal to the hole diameter R3 at the first minimum portion 15c of the first through hole 15. The hole diameter R6 at the second minimum portion 16c of the second through hole 16 is, for example, 20 µm or more, may be 35 µm or more, and may be 45 µm or more. The hole diameter R6 is, for example, 80 µm or less, may be 65 µm or less, and may be 55 µm or less.

The hole diameter R6 at the second minimum portion 16c of the second through hole 16 may be smaller than the hole diameter R3 at the first minimum portion 15c of the first through hole 15. In this case, the ratio of the hole diameter R6 to the hole diameter R3 is, for example, 0.2 or more, may be 0.3 or more, and may be 0.4 or more. The ratio of the hole diameter R6 to the hole diameter R3 is, for example, 0.7 or less, may be 0.6 or less, and may be 0.5 or less.

The third opening 16a may have a circular contour in plan view. In this case, the hole diameter R4 means the diameter of the third opening 16a. The fourth opening 16b may have a circular contour in plan view. In this case, the hole diameter R5 means the diameter of the fourth opening 16b. The second minimum portion 16c may have a circular contour in plan view. In this case, the hole diameter R6 means the diameter of the second minimum portion 16c.

The third opening 16a may have a contour other than a circular contour in plan view. In this case, the hole diameter R4 is calculated from the diameter of a circle obtained by converting the third opening 16a into a circle having a planar area equal to that of the third opening 16a. The fourth opening 16b may have a contour other than a circular contour in plan view. In this case, the hole diameter R5 is calculated from the diameter of a circle obtained by converting the fourth opening 16b into a circle having a planar area equal to that of the fourth opening 16b. The second minimum portion 16c may have a contour other than a circular contour in plan view. In this case, the hole diameter R6 is calculated from the diameter of a circle obtained by converting the second minimum portion 16c into a circle having a planar area equal to that of the second minimum portion 16c.

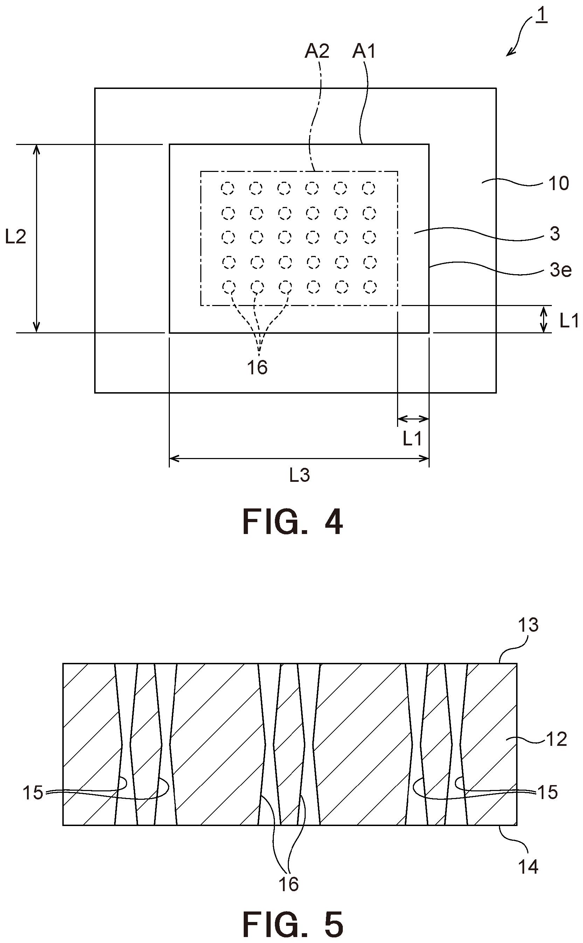

Fig. 4 is a plan view of the semiconductor package 1 in Fig. 1. The second through hole 16 may be located in the region A1 overlapping the semiconductor element 3 in plan view. The second through hole 16 may be located in a region overlapping a central portion of the semiconductor element 3 in plan view. In particular, the second through hole 16 may be located in a region A2 located 3 mm inside an outer peripheral edge 3e of the semiconductor element 3 in plan view.

The second through hole 16 may be located in a region located a distance L1 inside the outer peripheral edge 3e of the semiconductor element 3 in plan view. The distance L1 is, for example, 3 mm or more, may be 4 mm or more, and may be 5 mm or more. The distance L1 is, for example, 8 mm or less, may be 7 mm or less, and may be 6 mm or less.

A longitudinal dimension L2 of the semiconductor element 3 in plan view is, for example, 10 mm or more, may be 20 mm or more, and may be 30 mm or more. The same applies to a lateral dimension L3 of the semiconductor element 3 in plan view. In this case, the planar area of the semiconductor element 3 is, for example, 100 mm² or more, may be 400 mm² or more, and may be 900 mm² or more.

A plurality of second through holes 16 may be arranged at equal intervals in the region A1 overlapping the semiconductor element 3 in plan view. In particular, the plurality of second through holes 16 may be arranged at equal intervals in the region A2, which is located 3 mm inside the outer peripheral edge 3e of the semiconductor element 3 in plan view. In the example illustrated in Fig. 4, the plurality of second through holes 16 are arranged in a lattice pattern. Although not illustrated, the plurality of second through holes 16 may be arranged in a staggered pattern. The plurality of second through holes 16 may be arranged in any other pattern.

In the region A1 overlapping the semiconductor element 3 in plan view, 10 or more and 250 or less second through holes 16 per 100 mm² may be located. In particular, in the region A2, which is located 3 mm inside the outer peripheral edge 3e of the semiconductor element 3 in plan view, 10 or more and 250 or less second through holes 16 per 100 mm² may be located.

The number of second through holes 16 per 100 mm² is, for example, 10 or more, may be 50 or more, and may be 100 or more. The number of second through holes 16 per 100 mm² is, for example, 1000 or less, may be 500 or less, and may be 250 or less.

The second through hole 16 does not need to be located in a region not overlapping the semiconductor element 3 in plan view.

### Through Electrode

As illustrated in Figs. 1 and 2, the through electrode 20 is located in the first through hole 15. The through electrode 20 extends along the first through hole 15 from the first surface 13 to the second surface 14. The through electrode 20 is located along the first wall surface 15d and the second wall surface 15e of the first through hole 15.

The through electrode 20 closes the first through hole 15 between the first opening 15a and the second opening 15b. As illustrated in Fig. 2, the through electrode 20 may close the first through hole 15 at least at the first minimum portion 15c without closing the first through hole 15 at the first opening 15a and the second opening 15b. The through electrode 20 may include a first portion 21, a second portion 22, and a closing portion 23.

The first portion 21 is located between the first opening 15a and the first minimum portion 15c. The first portion 21 is located along the first wall surface 15d of the first through hole 15. The first portion 21 spreads along the first wall surface 15d of the first through hole 15 so as to surround the center of the first opening 15a of the first through hole 15 in plan view. The first portion 21 is a portion that does not close the first through hole 15. A first recess 21c of the through electrode 20 is formed in a region surrounded by the first portion 21.

The second portion 22 is located between the second opening 15b and the first minimum portion 15c. The second portion 22 is located on the side opposite to the first portion 21 in the thickness direction of the glass substrate 12. The second portion 22 is located along the second wall surface 15e of the first through hole 15. The second portion 22 spreads along the second wall surface 15e of the first through hole 15 so as to surround the center of the second opening 15b of the first through hole 15 in plan view. The second portion 22 is a portion that does not close the first through hole 15. A second recess 22c of the through electrode 20 is formed in a region surrounded by the second portion 22.

The closing portion 23 is located between the first portion 21 and the second portion 22. The closing portion 23 is located along the first wall surface 15d, the second wall surface 15e, and the first minimum portion 15c of the first through hole 15. The closing portion 23 may be located midway between the first opening 15a and the second opening 15b. The closing portion 23 is a portion that closes the first through hole 15.

As illustrated in Fig. 3, the through electrode 20 does not need to be located in the second through hole 16.

The through electrode 20 has conductivity. The through electrode 20 may include at least a plating material. The plating material may include, for example, a metal such as copper, gold, silver, platinum, rhodium, tin, aluminum, nickel, titanium, chromium, or zinc, or an alloy using these. A major portion of the through electrode 20 may be composed of the plating material. Although not illustrated, the through electrode 20 may include a seed layer. The seed layer may be located between the plating material and the first wall surface 15d and the second wall surface 15e of the first through hole 15.

### Resin Member

As illustrated in Figs. 1 and 3, the resin member 30 is located in the second through hole 16. The resin member 30 continuously extends from the third opening 16a to the fourth opening 16b in the second through hole 16. Specifically, the resin member 30 extends from the third opening 16a to the fourth opening 16b without interruption. As illustrated in Fig. 3, the resin member 30 may fill the second through hole 16. In other words, the resin member 30 may fill the inside of the second through hole 16 without a gap.

As illustrated in Figs. 1 and 2, the resin member 30 may be located in the first through hole 15. As illustrated in Fig. 2, the resin member 30 may be located in the first recess 21c and the second recess 22c of the through electrode 20 in the first through hole 15. The resin member 30 may fill the first recess 21c and the second recess 22c of the through electrode 20. In other words, the resin member 30 may fill the first recess 21c and the second recess 22c of the through electrode 20 without a gap.

The resin member 30 has insulation properties and heat resistance. The resin member 30 is composed of a resin material. Examples of the resin material include organic materials such as polyimide, epoxy, acrylic, and polyphenyl ether.

A water vapor permeability of the resin member 30 measured in accordance with JIS K7129-1: 2019 in an environment of a temperature of 40°C and a relative humidity of 90% is, for example, 10 g/(m²·day) or more, may be 50 g/(m²·day) or more, and may be 100 g/(m²·day) or more. The water vapor permeability is measured using a water vapor permeability measuring apparatus. An example of the water vapor permeability measuring apparatus to be used is Super Detect (manufactured by MS Scientific Co., Ltd.).

### Wiring Layer

As illustrated in Fig. 1, the wiring layer 40 is located between the glass substrate 12 and the semiconductor element 3. The wiring layer 40 may be located on the first surface 13 of the glass substrate 12. The wiring layer 40 is electrically connected to the through electrodes 20 of the glass substrate 12. The wiring layer 40 includes an insulating layer 41 and a conductive layer 42.

The insulating layer 41 extends over the first surface 13 of the glass substrate 12. The conductive layer 42 is located inside the insulating layer 41. The conductive layer 42 includes wires and pads. The wires are portions that extend in longitudinal and lateral directions inside the insulating layer 41, without being exposed from the insulating layer 41. The pads are portions that are partially exposed from the insulating layer 41 and are electrically in contact with other members.

The wiring layer 40 may include a plurality of wiring layers stacked on one another. In the example illustrated in Fig. 1, the wiring layer 40 includes a first wiring layer 40A and a second wiring layer 40B. The first wiring layer 40A is located on the first surface 13 of the glass substrate 12. The second wiring layer 40B is located on the first wiring layer 40A. The second wiring layer 40B is stacked on the first wiring layer 40A. Although not illustrated, the wiring layer 40 may include another wiring layer. The plurality of wiring layers may each include an insulating layer 41 and a conductive layer 42.

The semiconductor element 3 may be located on the wiring layer 40. The wiring layer 40 is electrically connected to the semiconductor element 3. The wiring layer 40 may be electrically connected to the semiconductor element 3 by bumps 43. With this configuration, the wiring layer 40 electrically connects the through electrodes 20 of the glass substrate 12 and the semiconductor element 3. An adhesive layer 44 may be located between the wiring layer 40 and the semiconductor element 3. The wiring layer 40 and the semiconductor element 3 may be bonded to each other by the adhesive layer 44.

The insulating layer 41 has insulation properties. The insulating layer 41 may include an organic material. Examples of the organic material include polyimide and epoxy. The conductive layer 42 has conductivity. The conductive layer 42 may include at least a plating material. The plating material may include, for example, a metal such as copper, gold, silver, platinum, rhodium, tin, aluminum, nickel, titanium, chromium, or zinc, or an alloy using these. A major portion of the conductive layer 42 may be composed of the plating material. Although not illustrated, the conductive layer 42 may include a seed layer. Plating may be formed on the seed layer.

The thickness T1 of the wiring layer 40 is, for example, 20 µm or more, may be 30 µm or more, and may be 35 µm or more. The thickness T1 of the wiring layer 40 is, for example, 60 µm or less, may be 50 µm or less, and may be 45 µm or less.

As illustrated in Fig. 1, a wiring layer 45 may be located between the glass substrate 12 and the mounting substrate 2. The wiring layer 45 may be located on the second surface 14 of the glass substrate 12. The wiring layer 45 may be electrically connected to the through electrodes 20 of the glass substrate 12. The wiring layer 45 may include an insulating layer 41 and a conductive layer 42.

The wiring layer 45 may include a plurality of wiring layers stacked on one another. In the example illustrated in Fig. 1, the wiring layer 45 includes a third wiring layer 45A and a fourth wiring layer 45B. The third wiring layer 45A is located on the second surface 14 of the glass substrate 12. The fourth wiring layer 45B is located on the third wiring layer 45A. The fourth wiring layer 45B is stacked on the third wiring layer 45A. Although not illustrated, the wiring layer 45 may include another wiring layer. The plurality of wiring layers may each include an insulating layer 41 and a conductive layer 42.

The mounting substrate 2 may be located below the wiring layer 45. The wiring layer 45 may be electrically connected to the mounting substrate 2. The wiring layer 45 may be electrically connected to the mounting substrate 2 via solder balls 46. With this configuration, the wiring layer 45 electrically connects the through electrodes 20 of the glass substrate 12 and the mounting substrate 2. In this manner, the semiconductor element 3 and the mounting substrate 2 are electrically connected to each other via the wiring layers 40 and 45 and the through electrodes 20.

The thickness T2 of the wiring layer 45 is, for example, 20 µm or more, may be 30 µm or more, and may be 35 µm or more. The thickness T2 of the wiring layer 45 is, for example, 60 µm or less, may be 50 µm or less, and may be 45 µm or less. The thickness T2 of the wiring layer 45 may be equal to the thickness T1 of the wiring layer 40. The thickness T2 of the wiring layer 45 may be smaller than or larger than the thickness T1 of the wiring layer 40.

The dimensions (thickness, hole diameter, distance, and the like) of the above-described components of the through electrode substrate 10 are calculated based on an image captured by a scanning electron microscope.

### Method for Manufacturing Semiconductor Package

A method for manufacturing the semiconductor package 1 will be described. The method for manufacturing the semiconductor package 1 includes a through electrode substrate manufacturing step and a semiconductor element mounting step. In the through electrode substrate manufacturing step, the through electrode substrate 10 is manufactured in accordance with the following method for manufacturing the through electrode substrate 10.

### Method for Manufacturing Through Electrode Substrate

A method for manufacturing the through electrode substrate 10 will be described. The method for manufacturing the through electrode substrate 10 includes a glass substrate preparation step, a through electrode forming step, a resin member forming step, and a wiring layer forming step.

### Glass Substrate Preparation Step

First, the glass substrate preparation step is performed. In the glass substrate preparation step, as illustrated in Fig. 5, the glass substrate 12 is prepared. As described above, the glass substrate 12 includes the first surface 13, the second surface 14, and the first through hole 15 and the second through hole 16. The glass substrate preparation step may include a through hole forming step.

In the through hole forming step, the first through hole 15 and the second through hole 16 are formed in the glass substrate 12. More specifically, first, a resist layer is formed on at least one of the first surface 13 or the second surface 14 of the glass substrate 12. Subsequently, openings are formed in the resist layer at positions corresponding to the first through hole 15 and the second through hole 16. Next, the glass substrate 12 is processed at the openings of the resist layer. In this manner, the first through hole 15 and the second through hole 16 are formed in the glass substrate 12. Examples of the processing method for the glass substrate 12 include a dry etching method and a wet etching method.

In the through hole forming step, the first through hole 15 and the second through hole 16 may be formed in the glass substrate 12 by irradiating the glass substrate 12 with a laser beam. In this case, the resist layer does not need to be provided. Furthermore, after irradiating the glass substrate 12 with a laser beam, an etching treatment by means of a wet etching method may be performed to form the first through hole 15 and the second through hole 16 in the glass substrate 12.

### Through Electrode Forming Step

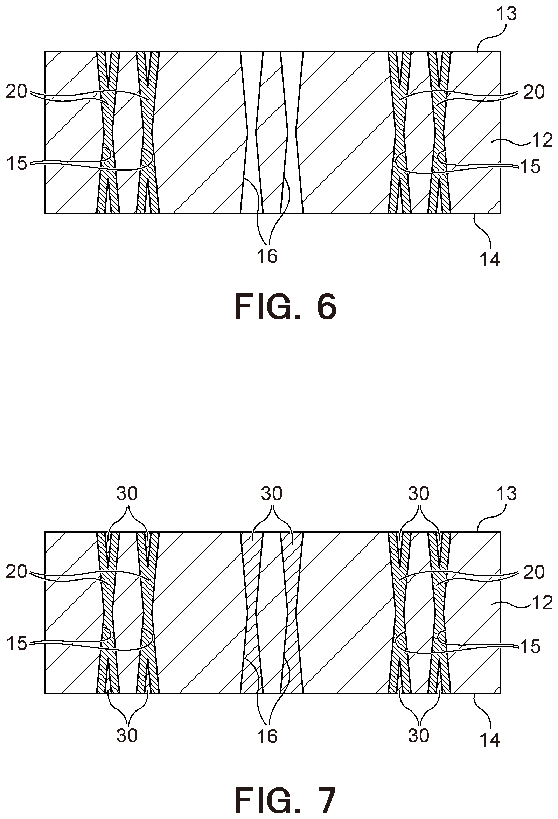

Subsequently, the through electrode forming step is performed. In the through electrode forming step, as illustrated in Fig. 6, the through electrode 20 is formed in the first through hole 15. The through electrode forming step may include a plating forming step.

In the plating forming step, plating is formed in the first through hole 15. More specifically, first, a seed layer is formed in the first through hole 15 of the glass substrate 12. For example, the seed layer is formed by a method such as sputtering. Subsequently, resist layers are formed on the first surface 13 and the second surface 14 of the glass substrate 12. Next, plating is formed in the first through hole 15 by an electrolytic plating method. For example, the glass substrate 12 is immersed in an electrolytic plating solution. Then, by causing a current to flow through the seed layer, plating is deposited on the seed layer. Thereafter, the resist layers are removed from the first surface 13 and the second surface 14 of the glass substrate 12. In this manner, the through electrode 20 is formed in the first through hole 15.

### Resin Member Forming Step

Next, the resin member forming step is performed. In the resin member forming step, as illustrated in Fig. 7, the resin member 30 is formed in the second through hole 16. More specifically, first, a liquid resin material is poured into the second through hole 16. Subsequently, the resin material in the second through hole 16 is cured. The resin material may be thermally cured. The resin material may be of a photosensitive type. The inside of the resin material may be photo-cured, or light irradiation may not be required. For example, the resin material is cured by irradiating the resin material with ultraviolet light. In this manner, the resin member 30 is formed in the second through hole 16.

In the resin member forming step, as illustrated in Fig. 7, the resin member 30 may be formed in the first through hole 15. More specifically, first, a liquid resin material is poured into the first recess 21c and the second recess 22c of the through electrode 20 in the first through hole 15. Subsequently, the resin material in the first through hole 15 is cured. For example, the resin material is cured by irradiating the resin material with ultraviolet light. In this manner, the resin member 30 is formed in the first through hole 15.

### Wiring Layer Forming Step

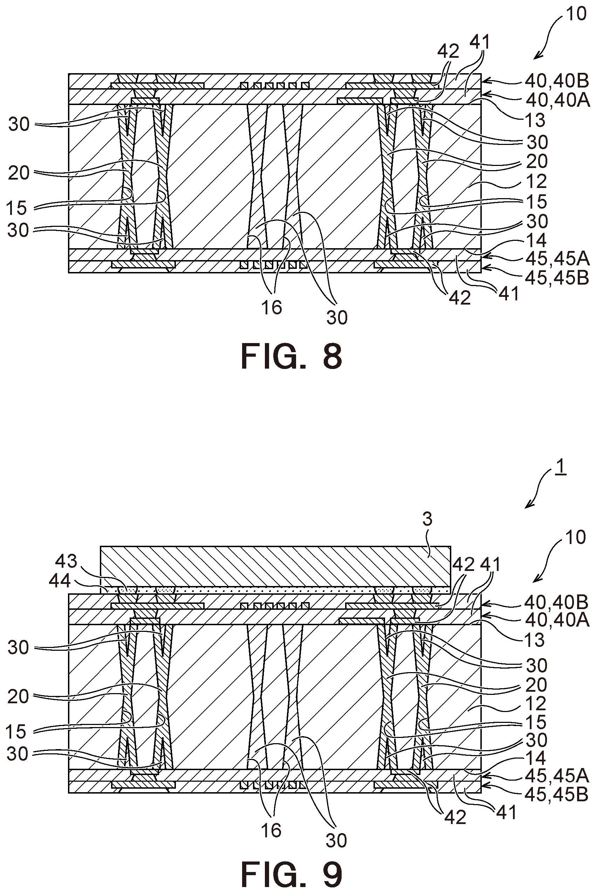

Thereafter, the wiring layer forming step is performed. In the wiring layer forming step, as illustrated in Fig. 8, the wiring layer 40 is formed on the first surface 13 of the glass substrate 12. The wiring layer forming step may include a conductive layer forming step and an insulating layer forming step.

In the conductive layer forming step, the conductive layer 42 is formed on the first surface 13 of the glass substrate 12. More specifically, first, a seed layer is formed on the first surface 13 of the glass substrate 12. For example, the seed layer is formed by a sputtering method. Subsequently, a resist layer is formed on the seed layer. The resist layer is formed at positions where the conductive layer 42 is not to be formed. Next, a plating layer is formed on portions of the seed layer not covered with the resist layer by means of an electrolytic plating method. For example, the glass substrate 12 is immersed in an electrolytic plating solution. Then, by causing a current to flow through the seed layer, plating is deposited on the seed layer. Thereafter, the resist layer is removed from the first surface 13 of the glass substrate 12. The seed layer on the resist layer is also removed. In the insulating layer forming step, the insulating layer 41 is formed on the first surface 13 of the glass substrate 12 so as to straddle the conductive layer 42. A plurality of wiring layers stacked on one another may be formed by repeatedly forming the conductive layer 42 and the insulating layer 41. In this manner, the wiring layer 40 is formed on the first surface 13 of the glass substrate 12.

In the wiring layer forming step, the wiring layer 45 may be formed on the second surface 14 of the glass substrate 12 by a similar method, as illustrated in Fig. 8.

As described above, the through electrode substrate 10 including the glass substrate 12, the through electrode 20, the resin member 30, and the wiring layer 40 is obtained.

### Semiconductor Element Mounting Step

Then, the semiconductor element mounting step is performed. In the semiconductor element mounting step, as illustrated in Fig. 9, the semiconductor element 3 is mounted on the through electrode substrate 10. More specifically, the semiconductor element 3 is disposed on the wiring layer 40 of the through electrode substrate 10. The semiconductor element 3 is disposed on the wiring layer 40 such that the wiring layer 40 and the semiconductor element 3 are electrically connected to each other. The wiring layer 40 and the semiconductor element 3 may be electrically connected to each other by the bumps 43. The adhesive layer 44 may be disposed between the wiring layer 40 and the semiconductor element 3. The wiring layer 40 and the semiconductor element 3 may be bonded to each other by the adhesive layer 44.

Through these steps, the semiconductor package 1 including the through electrode substrate 10 and the semiconductor element 3 is obtained.

The thus-obtained semiconductor package 1 is mounted on the mounting substrate 2, as illustrated in Fig. 1. The semiconductor package 1 may be mounted on the mounting substrate 2 such that the wiring layer 45 and the mounting substrate 2 are electrically connected to each other. The wiring layer 45 and the mounting substrate 2 may be electrically connected to each other via the solder balls 46. In this manner, the semiconductor element 3 and the mounting substrate 2 are electrically connected to each other via the wiring layers 40 and 45 and the through electrode 20.

As described above, the wiring layer may include a gas component. Examples of the gas component include a residual solvent, a component decomposed by thermal decomposition, and water vapor resulting from evaporation of moisture absorbed in a reliability test. The gas component contained in the wiring layer needs to be discharged to the outside. However, when the wiring layer is disposed between the glass substrate and the semiconductor element, because the glass substrate and the semiconductor element hardly allow gas to permeate therethrough, the gas component contained in the wiring layer is not easily discharged to the outside. Hence, the gas component contained in the wiring layer cannot be sufficiently discharged to the outside, and the gas component may be retained in the wiring layer. Due to the retained gas component, the wiring layer may expand, and the wiring layer may peel from the glass substrate. As a result, the reliability of the through electrode substrate may decrease.

In contrast, according to this embodiment, the glass substrate 12 includes the second through hole 16. The resin member 30 continuously extends from the third opening 16a to the fourth opening 16b in the second through hole 16. Hence, the gas component in the wiring layer 40 can be discharged to the outside from the second surface 14 side through the second through hole 16, and retention of the gas component in the wiring layer 40 can be suppressed. Hence, it is possible to suppress expansion of the wiring layer 40 and peeling of the wiring layer 40 from the glass substrate 12 due to the retained gas component. As a result, the reliability of the through electrode substrate 10 can be increased.

Furthermore, according to this embodiment, the resin member 30 fills the second through hole 16. Hence, the gas component in the wiring layer 40 can smoothly pass through the second through hole 16 without remaining in the second through hole 16. Hence, the gas component in the wiring layer 40 can be effectively discharged to the outside from the second surface 14 side. As a result, the reliability of the through electrode substrate 10 can be further increased.

Furthermore, according to this embodiment, the second through hole 16 has the same shape as the first through hole 15. Hence, in the process of manufacturing the through electrode substrate 10, the first through hole 15 and the second through hole 16 can be collectively formed in the glass substrate 12 without distinguishing the first through hole 15 and the second through hole 16 from each other. Hence, manufacture of the through electrode substrate 10 can be facilitated, and an increase in the manufacturing cost of the through electrode substrate 10 can be suppressed.

Furthermore, in this embodiment, the second through hole 16 is located in the region A1 overlapping the semiconductor element 3 in plan view. The gas component in the wiring layer 40 is not easily discharged to the outside in the region A1 overlapping the semiconductor element 3 in plan view. In other words, in the region A1 overlapping the semiconductor element 3 in plan view, the gas component in the wiring layer 40 is not easily discharged to the outside due to the presence of the semiconductor element 3, which hardly allows gas to permeate therethrough. Hence, because the second through hole 16 is located in the region A1 overlapping the semiconductor element 3 in plan view, the gas component in the wiring layer 40 can be effectively discharged to the outside from the second surface 14 side through the second through hole 16.

Furthermore, according to this embodiment, the second through hole 16 is located in the region A2, which is located 3 mm inside the outer peripheral edge 3e of the semiconductor element 3 in plan view. The gas component in the wiring layer 40 is less likely to be discharged to the outside in the region overlapping the central portion of the semiconductor element 3 in plan view than in the region overlapping the peripheral portion of the semiconductor element 3 in plan view. Specifically, in the region overlapping the peripheral portion of the semiconductor element 3 in plan view, the gas component in the wiring layer 40 can flow in a planar direction (a direction orthogonal to the thickness direction) and can be discharged to the outside from a region not overlapping the semiconductor element 3 in plan view. On the other hand, in the region overlapping the central portion of the semiconductor element 3 in plan view, because the distance to the outer peripheral edge 3e of the semiconductor element 3 is long, the gas component in the wiring layer 40 is not easily discharged to the outside from a region not overlapping the semiconductor element 3 in plan view. In particular, in the region A2, which is located 3 mm inside the outer peripheral edge 3e of the semiconductor element 3 in plan view, the gas component in the wiring layer 40 is not easily discharged to the outside. Hence, because the second through hole 16 is located in the region A2, which is located 3 mm inside the outer peripheral edge 3e of the semiconductor element 3 in plan view, the gas component in the wiring layer 40 can be effectively discharged to the outside from the second surface 14 side through the second through hole 16.

Furthermore, according to this embodiment, the plurality of second through holes 16 are arranged at equal intervals in the region A1 overlapping the semiconductor element 3 in plan view. Hence, the gas component in the wiring layer 40 can be uniformly discharged in the plane. Hence, the gas component in the wiring layer 40 can be more effectively discharged to the outside.

Furthermore, according to this embodiment, 10 or more and 250 or less second through holes 16 per 100 mm² are located in the region A1 overlapping the semiconductor element 3 in plan view. When the number of the second through holes 16 per 100 mm² is 10 or more, the gas component contained in the wiring layer 40 can be appropriately discharged to the outside. On the other hand, when the number of the second through holes 16 per 100 mm² is 250 or less, a decrease in connection density can be suppressed.

Furthermore, according to this embodiment, the planar area of the semiconductor element 3 is 100 mm² or more. In particular, when such a large semiconductor element 3 is mounted on the through electrode substrate 10, the gas component in the wiring layer 40 is not easily discharged to the outside. In other words, in a region overlapping the central portion of the semiconductor element 3 in plan view, the distance to the outer peripheral edge 3e of the semiconductor element 3 is long, and the gas component in the wiring layer 40 is not easily discharged to the outside from a region not overlapping the semiconductor element 3 in plan view. This embodiment can be suitably applied to the through electrode substrate 10 on which such a large semiconductor element 3 is mounted.

The above-described embodiment can be modified in various ways. Hereinbelow, modifications will be described with reference to the drawings as necessary. In the following description and the drawings referred to in the following description, portions configured in the same manner as those in the above-described embodiment are denoted by the same reference numerals as those for corresponding portions in the above-described embodiment. Repeated description is omitted. Furthermore, when it is clear that the effects obtained in the above-described embodiment are also obtained in the modifications, description thereof may also be omitted.

### First Modification

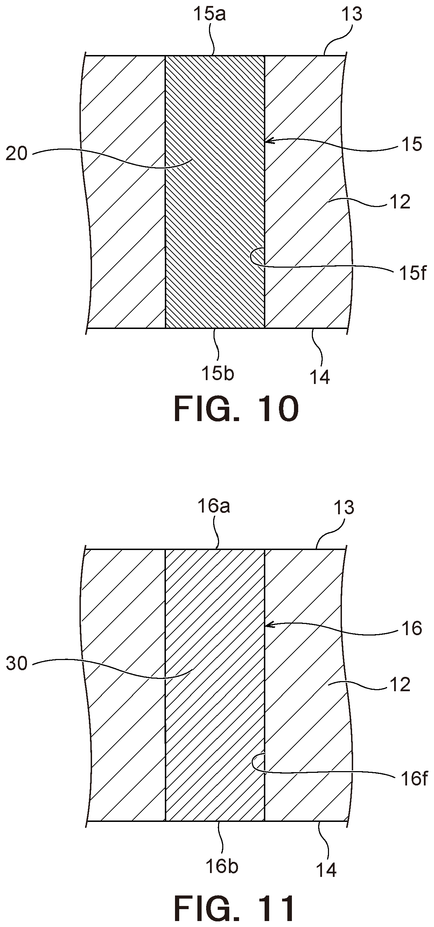

Fig. 10 is a cross-sectional view illustrating a modification of the first through hole 15 in Fig. 2. As illustrated in Fig. 10, the first through hole 15 may be formed in a cylindrical shape. The first through hole 15 does not need to include the first minimum portion 15c, as illustrated in Fig. 2. For example, the hole diameter of the first through hole 15 may be constant from the first opening 15a to the second opening 15b. The wall surface 15f of the first through hole 15 may extend straight from the first opening 15a to the second opening 15b.

In this case, the through electrode 20 may fill the first through hole 15. In other words, the through electrode 20 may fill the inside of the first through hole 15 without a gap. The through electrode 20 may close the first through hole 15 at the first opening 15a and the second opening 15b. The through electrode 20 may close the first through hole 15 in the entire region between the first opening 15a and the second opening 15b.

Fig. 11 is a cross-sectional view illustrating a modification of the second through hole 16 in Fig. 3. As illustrated in Fig. 11, the second through hole 16 may also be formed in a cylindrical shape. Specifically, the second through hole 16 may have the same shape as the first through hole 15. The second through hole 16 does not need to include the second minimum portion 16c, as illustrated in Fig. 3. For example, the hole diameter of the second through hole 16 may be constant from the third opening 16a to the fourth opening 16b. The wall surface 16f of the second through hole 16 may extend straight from the third opening 16a to the fourth opening 16b.

Also in this case, the resin member 30 continuously extends in the second through hole 16 from the third opening 16a to the fourth opening 16b. Specifically, the resin member 30 extends from the third opening 16a to the fourth opening 16b without interruption. The resin member 30 may fill the second through hole 16. In other words, the resin member 30 may fill the inside of the second through hole 16 without a gap.

### Second Modification

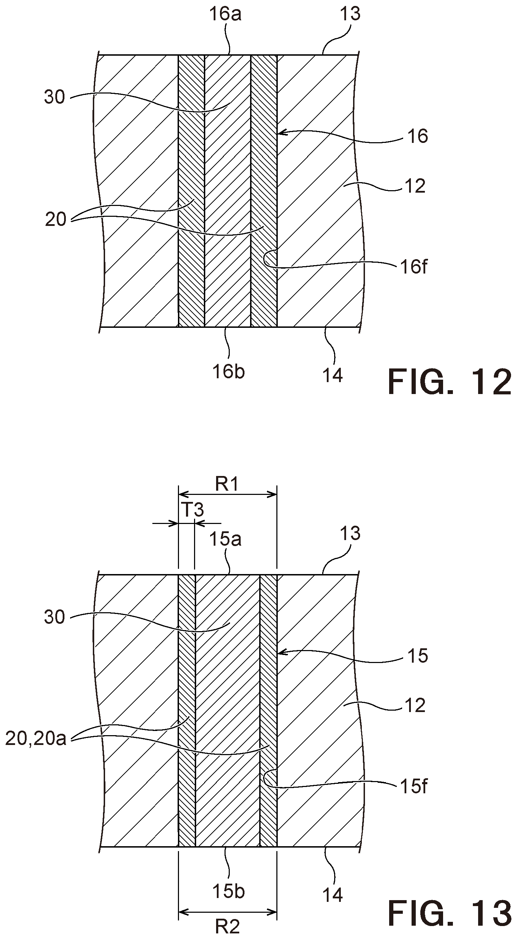

Fig. 12 is a cross-sectional view illustrating another modification of the second through hole 16 in Fig. 11. As illustrated in Fig. 12, the through electrode 20 may be located in the second through hole 16. The through electrode 20 may extend along the second through hole 16 from the first surface 13 to the second surface 14. The through electrode 20 may be located along the wall surface 16f of the second through hole 16. The through electrode 20 may be formed in a cylindrical shape along the wall surface 16f of the second through hole 16. The through electrode 20 does not close the second through hole 16 at any position between the third opening 16a and the fourth opening 16b.

Also in this case, the resin member 30 continuously extends in the second through hole 16 from the third opening 16a to the fourth opening 16b. Specifically, the resin member 30 extends from the third opening 16a to the fourth opening 16b without interruption. The resin member 30 may be located inside the through electrode 20 in the second through hole 16. The resin member 30 may fill the inside of the through electrode 20. In other words, the resin member 30 may fill the inside of the through electrode 20 without a gap.

### Third Modification

Fig. 13 is a cross-sectional view illustrating another modification of the first through hole 15 in Fig. 2. As illustrated in Fig. 13, the first through hole 15 may be formed in a cylindrical shape. The first through hole 15 does not need to include the first minimum portion 15c, as illustrated in Fig. 2. For example, the hole diameter of the first through hole 15 may be constant from the first opening 15a to the second opening 15b. The first through hole 15 includes a wall surface 15f (a first wall surface) located between the first opening 15a and the second opening 15b. The wall surface 15f of the first through hole 15 may extend straight from the first opening 15a to the second opening 15b.

The hole diameter R1 at the first opening 15a of the first through hole 15 is the same as that in the example illustrated in Fig. 2. Specifically, the hole diameter R1 is, for example, 50 µm or more, may be 65 µm or more, and may be 75 µm or more. The hole diameter R1 is, for example, 100 µm or less, may be 90 µm or less, and may be 85 µm or less. The same applies to the hole diameter R2 at the second opening 15b of the first through hole 15. The hole diameter R2 may be equal to the hole diameter R1. The hole diameter R2 may be smaller than or larger than the hole diameter R1.

As illustrated in Fig. 13, the through electrode 20 is located in the first through hole 15. The through electrode 20 located in the first through hole 15 is also referred to as a through electrode 20a. The through electrode 20a extends along the wall surface 15f of the first through hole 15 from the first opening 15a to the second opening 15b. The through electrode 20a may be formed in a cylindrical shape along the wall surface 15f of the first through hole 15. The through electrode 20a does not need to close the first through hole 15 between the first opening 15a and the second opening 15b.

The thickness T3 of the through electrode 20a is, for example, 5 µm or more, may be 8 µm or more, and may be 10 µm or more. The thickness T3 is, for example, 25 µm or less, may be 20 µm or less, and may be 15 µm or less. The thickness T3 is a dimension of the through electrode 20a in a plane orthogonal to the thickness direction of the glass substrate 12 and is a dimension of the through electrode 20a along the radial direction of the first through hole 15. The thickness T3 is measured at a position midway between the first opening 15a and the second opening 15b.

As illustrated in Fig. 13, the resin member 30 may be located in the first through hole 15. The resin member 30 may be located inside the through electrode 20a in the first through hole 15. The resin member 30 may be formed on the through electrode 20a in the first through hole 15. The resin member 30 may continuously extend in the first through hole 15 from the first opening 15a to the second opening 15b. In other words, the resin member 30 may extend from the first opening 15a to the second opening 15b without interruption. The resin member 30 may fill the inside of the through electrode 20a. In other words, the resin member 30 may fill the inside of the through electrode 20a without a gap.

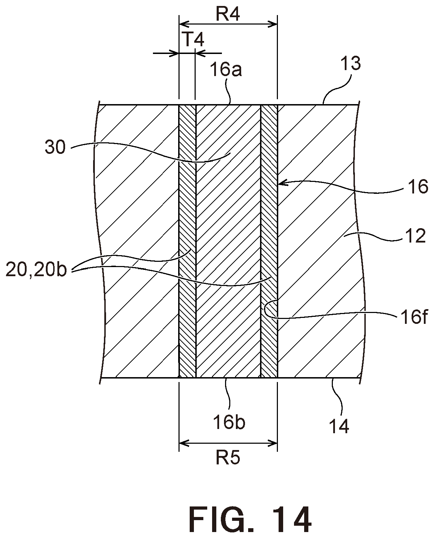

Fig. 14 is a cross-sectional view illustrating another modification of the second through hole 16 in Fig. 3. As illustrated in Fig. 14, the second through hole 16 may have the same shape as the first through hole 15 illustrated in Fig. 13. Specifically, as illustrated in Fig. 14, the second through hole 16 may be formed in a cylindrical shape. The second through hole 16 does not need to include the second minimum portion 16c as illustrated in Fig. 3. For example, the hole diameter of the second through hole 16 may be constant from the third opening 16a to the fourth opening 16b. The second through hole 16 includes a wall surface 16f (a second wall surface) located between the third opening 16a and the fourth opening 16b. The wall surface 16f of the second through hole 16 may extend straight from the third opening 16a to the fourth opening 16b.

The hole diameter R4 at the third opening 16a of the second through hole 16 is the same as that in the example illustrated in Fig. 3. In other words, the hole diameter R4 at the third opening 16a of the second through hole 16 may be equal to the hole diameter R1 at the first opening 15a of the first through hole 15. The hole diameter R5 at the fourth opening 16b of the second through hole 16 may also be equal to the hole diameter R2 at the second opening 15b of the first through hole 15. The hole diameter R4 is, for example, 50 µm or more, may be 65 µm or more, and may be 75 µm or more. The hole diameter R4 is, for example, 100 µm or less, may be 90 µm or less, and may be 85 µm or less. The same applies to the hole diameter R5 at the fourth opening 16b of the second through hole 16. The hole diameter R5 may be equal to the hole diameter R4. The hole diameter R5 may be smaller than or larger than the hole diameter R4.

As illustrated in Fig. 14, the through electrode 20 is also located in the second through hole 16. The through electrode 20 located in the second through hole 16 is also referred to as a through electrode 20b. The through electrode 20b extends along the wall surface 16f of the second through hole 16 from the third opening 16a to the fourth opening 16b. The through electrode 20b may be formed in a cylindrical shape along the wall surface 16f of the second through hole 16. The through electrode 20b does not close the second through hole 16 between the third opening 16a and the fourth opening 16b.

The thickness T4 of the through electrode 20b is, for example, 5 µm or more, may be 8 µm or more, and may be 10 µm or more. The thickness T4 is, for example, 25 µm or less, may be 20 µm or less, and may be 15 µm or less. The thickness T4 is a dimension of the through electrode 20b in a plane orthogonal to the thickness direction of the glass substrate 12 and is a dimension of the through electrode 20b along the radial direction of the second through hole 16. The thickness T4 is measured at a position midway between the third opening 16a and the fourth opening 16b.

The thickness T4 of the through electrode 20b may be equal to the thickness T3 of the through electrode 20a. In this case, when manufacturing the through electrode substrate 10, an increase in the number of steps in the plating forming step and in the plating forming time for forming the through electrodes 20a and 20b can be suppressed. The thickness T4 of the through electrode 20b may be smaller than or larger than the thickness T3 of the through electrode 20a. For example, when the thickness T3 is larger than the thickness T4, that is, when the thickness T4 is smaller than the thickness T3, the gas component in the wiring layer 40 can be effectively discharged while ensuring connection density.

As illustrated in Fig. 14, the resin member 30 is located in the second through hole 16. The resin member 30 is located inside the through electrode 20b in the second through hole 16. The resin member 30 is formed on the through electrode 20b in the second through hole 16. The resin member 30 continuously extends from the third opening 16a to the fourth opening 16b in the second through hole 16. Specifically, the resin member 30 extends from the third opening 16a to the fourth opening 16b without interruption. The resin member 30 may fill the inside of the through electrode 20b. In other words, the resin member 30 may fill the inside of the through electrode 20b without a gap.

Also in this case, because the resin member 30 continuously extends in the second through hole 16 from the third opening 16a to the fourth opening 16b, the gas component in the wiring layer 40 can be discharged to the outside from the second surface 14 side through the second through hole 16. Hence, retention of the gas component in the wiring layer 40 can be suppressed.

In particular, the hole diameter R4 at the third opening 16a of the second through hole 16 is 50 µm or more and 100 µm or less, and the thickness T4 of the through electrode 20b is 5 µm or more and 25 µm or less. This enables the gas component in the wiring layer 40 to be effectively discharged while ensuring connection density.

Furthermore, also in this case, 27 or more and 2500 or less second through holes 16 per 100 mm² may be located in the region A1 overlapping the semiconductor element 3 in plan view. In particular, 27 or more and 2500 or less second through holes 16 per 100 mm² may be located in the region A2, which is located 3 mm inside the outer peripheral edge 3e of the semiconductor element 3 in plan view.

The number of second through holes 16 per 100 mm² is, for example, 27 or more, may be 500 or more, and may be 1000 or more. The number of second through holes 16 per 100 mm² is, for example, 3500 or less, may be 3000 or less, and may be 2500 or less.

Because 27 or more and 2500 or less second through holes 16 per 100 mm² are located in the region A1 overlapping the semiconductor element 3 in plan view, generation of cracks can be suppressed while appropriately discharging the gas component contained in the wiring layer 40 to the outside.

### Fourth Modification

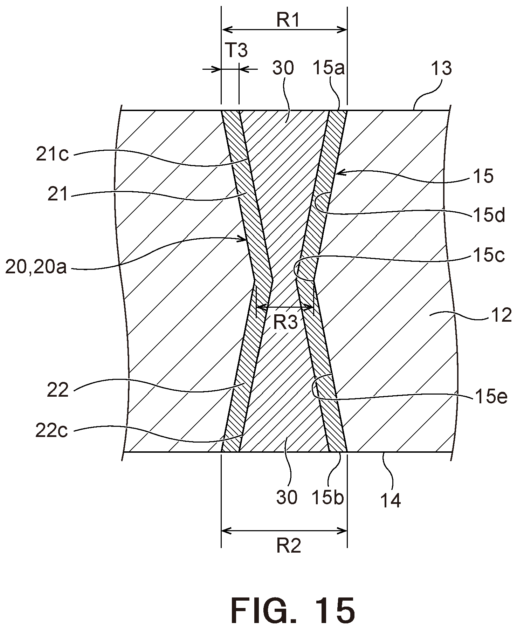

Fig. 15 is a cross-sectional view illustrating another modification of the first through hole 15 in Fig. 13. As illustrated in Fig. 15, the first through hole 15 may include the first minimum portion 15c, similarly to the example illustrated in Fig. 2. The first minimum portion 15c may be located midway between the first opening 15a and the second opening 15b. In this case, the through electrode 20a may extend along the wall surfaces 15d and 15e of the first through hole 15 from the first opening 15a to the second opening 15b. The through electrode 20a does not need to close the first through hole 15. In other words, the through electrode 20a does not need to include the closing portion 23 as illustrated in Fig. 2. In this case, the first recess 21c and the second recess 22c of the through electrode 20a may be connected at the first minimum portion 15c. Furthermore, similarly to the example illustrated in Fig. 13, the resin member 30 may be located inside the through electrode 20a in the first through hole 15. The resin member 30 may continuously extend in the first through hole 15 from the first opening 15a to the second opening 15b.

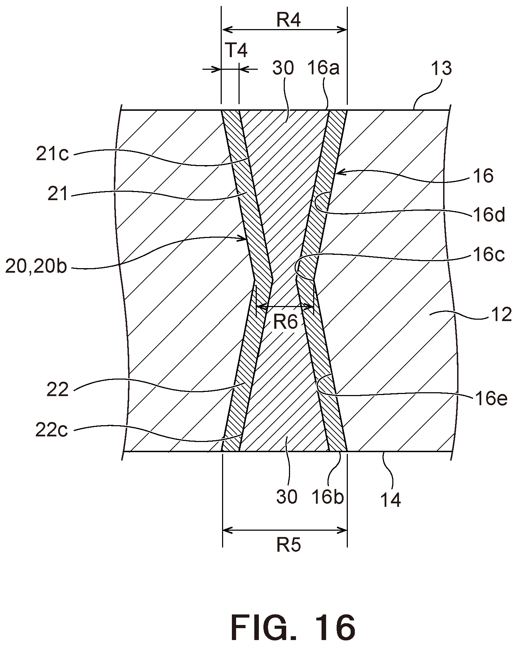

Fig. 16 is a cross-sectional view illustrating another modification of the second through hole 16 in Fig. 14. As illustrated in Fig. 16, the second through hole 16 may include the second minimum portion 16c, similarly to the example illustrated in Fig. 3. The second minimum portion 16c may be located midway between the third opening 16a and the fourth opening 16b. In this case, the through electrode 20b may extend along the wall surfaces 16d and 16e of the second through hole 16 from the third opening 16a to the fourth opening 16b. The through electrode 20b does not need to close the second through hole 16. In other words, the through electrode 20b does not need to include the closing portion 23 as illustrated in Fig. 3. In this case, the first recess 21c and the second recess 22c of the through electrode 20b may be connected at the second minimum portion 16c. Furthermore, similarly to the example illustrated in Fig. 14, the resin member 30 may be located inside the through electrode 20b in the second through hole 16. The resin member 30 may continuously extend in the second through hole 16 from the third opening 16a to the fourth opening 16b.

Also in this case, because the resin member 30 continuously extends in the second through hole 16 from the third opening 16a to the fourth opening 16b, the gas component in the wiring layer 40 can be discharged to the outside from the second surface 14 side through the second through hole 16. Hence, retention of the gas component in the wiring layer 40 can be suppressed.

In particular, the hole diameter R4 at the third opening 16a of the second through hole 16 is 50 µm or more and 100 µm or less, and the thickness T4 of the through electrode 20b is 5 µm or more and 25 µm or less. This enables the gas component in the wiring layer 40 to be effectively discharged while ensuring connection density.

Furthermore, because 27 or more and 2500 or less second through holes 16 per 100 mm² are located in the region A1 overlapping the semiconductor element 3 in plan view, generation of cracks can be suppressed while appropriately discharging the gas component contained in the wiring layer 40 to the outside.

### Examples of Products on Which Semiconductor Package Is Mounted

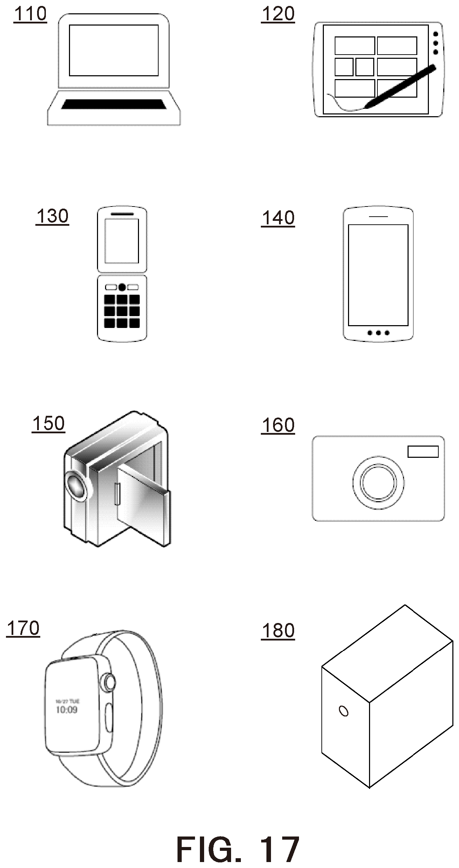

Fig. 17 is a diagram illustrating examples of products on which the semiconductor package 1 is mounted. The semiconductor package 1 can be used in various products. For example, the semiconductor package 1 is mounted in a laptop computer 110, a tablet device 120, a mobile phone 130, a smartphone 140, a digital video camera 150, a digital camera 160, a digital watch 170, a server 180, and the like.

It is also possible to appropriately combine the components disclosed in the above-described embodiment and the above-described modifications as necessary.

### Examples

Next, the embodiments of the present disclosure will be described more specifically with reference to examples. The embodiments of the present disclosure are not limited to the following description of the examples within a scope not departing from the gist thereof.

In the first example, the semiconductor package 1 illustrated in Figs. 1 to 4 was prepared. The thickness T0 of the through electrode substrate 10 was 400 µm. The longitudinal dimension and the lateral dimension of the glass substrate 12 in plan view were each 60 mm. Hence, the planar area of the glass substrate 12 was 3600 mm². The thickness T1 of the wiring layer 40 and the thickness T2 of the wiring layer 45 were each 40 µm. The longitudinal dimension L2 and the lateral dimension L3 of the semiconductor element 3 in plan view were each 10 mm. Hence, the planar area of the semiconductor element 3 was 100 mm².

The first through hole 15 and the second through hole 16 had the same shape. The hole diameter R1 at the first opening 15a of the first through hole 15 was 80 µm. The hole diameter R2 at the second opening 15b of the first through hole 15 was 80 µm. The hole diameter R3 at the first minimum portion 15c of the first through hole 15 was 50 µm. The hole diameter R4 at the third opening 16a of the second through hole 16 was 80 µm. The hole diameter R5 at the fourth opening 16b of the second through hole 16 was 80 µm. The hole diameter R6 at the second minimum portion 16c of the second through hole 16 was 50 µm.

The second through hole 16 was arranged in the region A1 overlapping the semiconductor element 3 in plan view. In the region A1 overlapping the semiconductor element 3 in plan view, a plurality of second through holes 16 were arranged in a lattice pattern at equal intervals. Semiconductor packages 1 were prepared in which the number of second through holes 16 in the region A1 overlapping the semiconductor element 3 (in a region of 10 mm × 10 mm) was set to 5, 10, 50, 100, 250, 500, and 1000.

For each of the thus-manufactured semiconductor packages 1, it was confirmed, using an electron microscope, whether expansion of the wiring layer 40 due to the gas component was present. When the expansion of the wiring layer 40 was 30 µm or more, it was evaluated as expansion "present", and when the expansion of the wiring layer 40 was less than 30 µm, it was evaluated as expansion "absent".
Furthermore, the connection density in each semiconductor package 1 was confirmed by measuring the electrical resistance of the connection wiring. When the change in the electrical resistance was 10% or more, it was evaluated as connection density "decreased", and when the change in the electrical resistance was less than 10%, it was evaluated as connection density "good".

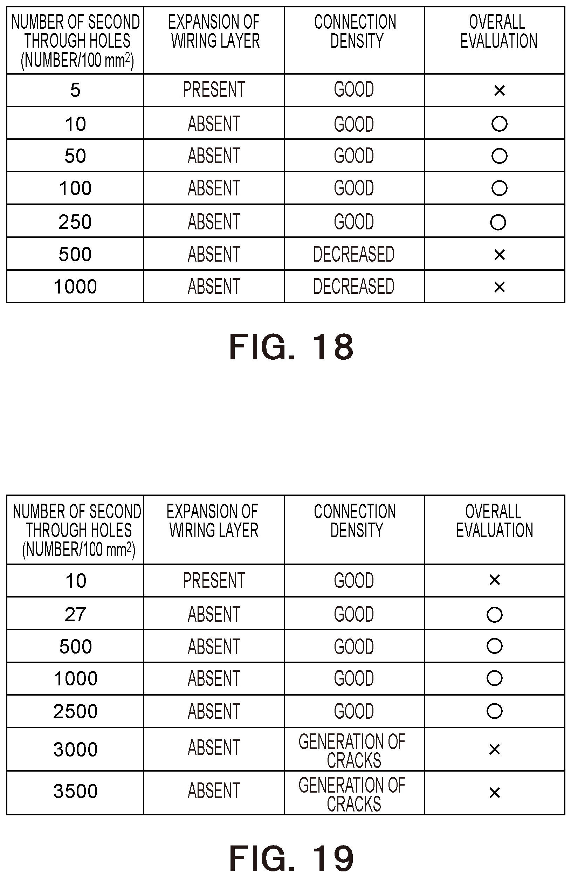

Fig. 18 is a table illustrating the evaluation results in the first example. As illustrated in Fig. 18, when the number of second through holes 16 per 100 mm² was 5, expansion of the wiring layer 40 was observed. It is considered that the gas component contained in the wiring layer 40 could not be sufficiently discharged to the outside when the number of second through holes 16 per 100 mm² was 5. On the other hand, when the number of second through holes 16 per 100 mm² was 10 or more, expansion of the wiring layer 40 was not observed. It is considered that the gas component contained in the wiring layer 40 could be appropriately discharged to the outside when the number of second through holes 16 per 100 mm² was 10 or more. Furthermore, when the number of second through holes 16 per 100 mm² was 500 or more, a decrease in connection density was observed. On the other hand, when the number of second through holes 16 per 100 mm² was 250 or less, the connection density was good. As an overall evaluation, it was confirmed that it is preferable that the number of second through holes 16 per 100 mm² be 10 or more and 250 or less.

In the second example, a semiconductor package 1 including the first through hole 15 and the through electrode 20a as illustrated in Fig. 15 and the second through hole 16 and the through electrode 20b as illustrated in Fig. 16 was prepared. The thickness T0 of the through electrode substrate 10 was 400 µm. The longitudinal dimension and the lateral dimension of the glass substrate 12 in plan view were each 60 mm. Hence, the planar area of the glass substrate 12 was 3600 mm². The thickness T1 of the wiring layer 40 and the thickness T2 of the wiring layer 45 were each 40 µm. The longitudinal dimension L2 and the lateral dimension L3 of the semiconductor element 3 in plan view were each 10 mm. Hence, the planar area of the semiconductor element 3 was 100 mm².

The first through hole 15 and the second through hole 16 had the same shape. The hole diameter R1 at the first opening 15a of the first through hole 15 was 80 µm. The hole diameter R2 at the second opening 15b of the first through hole 15 was 80 µm. The hole diameter R3 at the first minimum portion 15c of the first through hole 15 was 50 µm. The thickness T3 of the through electrode 20a was 10 µm. The hole diameter R4 at the third opening 16a of the second through hole 16 was 80 µm. The hole diameter R5 at the fourth opening 16b of the second through hole 16 was 80 µm. The hole diameter R6 at the second minimum portion 16c of the second through hole 16 was 50 µm. The thickness T4 of the through electrode 20b was 10 µm.

The second through hole 16 was arranged in the region A1 overlapping the semiconductor element 3 in plan view. In the region A1 overlapping the semiconductor element 3 in plan view, a plurality of second through holes 16 were arranged in a lattice pattern at equal intervals. Semiconductor packages 1 were prepared in which the number of second through holes 16 in the region A1 overlapping the semiconductor element 3 (in a region of 10 mm × 10 mm) was set to 10, 27, 500, 1000, 2500, 3000, and 3500.

As in the first example, for each of the thus-manufactured semiconductor packages 1, it was confirmed, using an electron microscope, whether expansion of the wiring layer 40 due to the gas component was present. Furthermore, as in the first example, the connection density in each semiconductor package 1 was confirmed by measuring the electrical resistance of the connection wiring.

Fig. 19 is a table illustrating the evaluation results in the second example. As illustrated in Fig. 19, when the number of second through holes 16 per 100 mm² was 10, expansion of the wiring layer 40 was observed. It is considered that the gas component contained in the wiring layer 40 could not be sufficiently discharged to the outside when the number of second through holes 16 per 100 mm² was 10. On the other hand, when the number of second through holes 16 per 100 mm² was 27 or more, expansion of the wiring layer 40 was not observed. It is considered that the gas component contained in the wiring layer 40 could be appropriately discharged to the outside when the number of second through holes 16 per 100 mm² was 27 or more. Furthermore, when the number of second through holes 16 per 100 mm² was 3000 or more, cracks occurred in the glass substrate 12 and the wiring layer 40. On the other hand, when the number of second through holes 16 per 100 mm² was 2500 or less, cracks did not occur, and the connection density was good. As an overall evaluation, it was confirmed that it is preferable that the number of second through holes 16 per 100 mm² be 27 or more and 2500 or less.

## Claims

1. A through electrode substrate on which a semiconductor element is to be mounted, comprising:
a glass substrate including a first surface, a second surface located on a side opposite to the first surface, and a first through hole and a second through hole extending from the first surface to the second surface;
a through electrode located in the first through hole;
a resin member located in the second through hole; and
a wiring layer located between the glass substrate and the semiconductor element, wherein
the first through hole includes a first opening that is open at the first surface of the glass substrate and a second opening that is open at the second surface of the glass substrate,
the second through hole includes a third opening that is open at the first surface of the glass substrate and a fourth opening that is open at the second surface of the glass substrate,
the through electrode closes the first through hole between the first opening and the second opening, and
the resin member continuously extends in the second through hole from the third opening to the fourth opening.

2. The through electrode substrate according to claim 1, wherein
the first through hole includes a first minimum portion located between the first opening and the second opening and having a minimum hole diameter of the first through hole, and
the through electrode does not close the first through hole at the first opening or the second opening and closes the first through hole at least at the first minimum portion.

3. The through electrode substrate according to claim 1, wherein the through electrode fills the first through hole.

4. The through electrode substrate according to claim 1, wherein the resin member fills the second through hole.

5. The through electrode substrate according to claim 1, wherein the second through hole has the same shape as the first through hole.

6. The through electrode substrate according to claim 1, wherein the second through hole is located in a region overlapping the semiconductor element in plan view.

7. The through electrode substrate according to claim 6, wherein the second through hole is located in a region located 3 mm inside an outer peripheral edge of the semiconductor element in plan view.

8. The through electrode substrate according to claim 6, wherein a plurality of the second through holes are arranged at equal intervals in the region overlapping the semiconductor element in plan view.

9. The through electrode substrate according to claim 6, wherein 10 or more and 250 or less second through holes are located per 100 mm² in the region overlapping the semiconductor element in plan view.

10. The through electrode substrate according to claim 1, wherein a hole diameter of the second through hole at the third opening is 50 µm or more and 100 µm or less.

11. The through electrode substrate according to claim 1, wherein a thickness of the glass substrate is 100 µm or more and 1200 µm or less.

12. The through electrode substrate according to claim 1, wherein a planar area of the semiconductor element is 100 mm² or more.

13. A through electrode substrate on which a semiconductor element is to be mounted, comprising:
a glass substrate including a first surface, a second surface located on a side opposite to the first surface, and a first through hole and a second through hole extending from the first surface to the second surface;
through electrodes respectively located in the first through hole and the second through hole;
a resin member located at least in the second through hole; and
a wiring layer located between the glass substrate and the semiconductor element, wherein
the first through hole includes a first opening that is open at the first surface of the glass substrate, a second opening that is open at the second surface of the glass substrate, and a first wall surface located between the first opening and the second opening,
the second through hole includes a third opening that is open at the first surface of the glass substrate, a fourth opening that is open at the second surface of the glass substrate, and a second wall surface located between the third opening and the fourth opening,
the through electrode located in the first through hole extends along the first wall surface from the first opening to the second opening,
the through electrode located in the second through hole extends along the second wall surface from the third opening to the fourth opening,
the resin member is located inside the through electrode in the second through hole and continuously extends from the third opening to the fourth opening,
a hole diameter of the second through hole at the third opening is 50 µm or more and 100 µm or less, and
a thickness of the through electrode located in the second through hole is 5 µm or more and 25 µm or less.

14. The through electrode substrate according to claim 13, wherein the second through hole is located in a region overlapping the semiconductor element in plan view.

15. The through electrode substrate according to claim 14, wherein 27 or more and 2500 or less second through holes are located per 100 mm² in the region overlapping the semiconductor element in plan view.

16. A semiconductor package comprising:
the through electrode substrate according to any one of claims 1 to 15; and
a semiconductor element mounted on the through electrode substrate.

17. A through electrode substrate comprising:
a glass substrate including a first surface, a second surface located on a side opposite to the first surface, and a first through hole and a second through hole extending from the first surface to the second surface;
a through electrode located in the first through hole; and
a resin member located in the second through hole, wherein
the first through hole includes a first opening that is open at the first surface of the glass substrate and a second opening that is open at the second surface of the glass substrate,
the second through hole includes a third opening that is open at the first surface of the glass substrate and a fourth opening that is open at the second surface of the glass substrate,
the through electrode closes the first through hole between the first opening and the second opening, and
the resin member continuously extends in the second through hole from the third opening to the fourth opening.

18. A through electrode substrate comprising:
a glass substrate including a first surface, a second surface located on a side opposite to the first surface, and a first through hole and a second through hole extending from the first surface to the second surface;
through electrodes respectively located in the first through hole and the second through hole; and
a resin member located at least in the second through hole, wherein
the first through hole includes a first opening that is open at the first surface of the glass substrate, a second opening that is open at the second surface of the glass substrate, and a first wall surface located between the first opening and the second opening,
the second through hole includes a third opening that is open at the first surface of the glass substrate, a fourth opening that is open at the second surface of the glass substrate, and a second wall surface located between the third opening and the fourth opening,
the through electrode located in the first through hole extends along the first wall surface from the first opening to the second opening,
the through electrode located in the second through hole extends along the second wall surface from the third opening to the fourth opening,
the resin member is located inside the through electrode in the second through hole and continuously extends from the third opening to the fourth opening,
a hole diameter of the second through hole at the third opening is 50 µm or more and 100 µm or less, and
a thickness of the through electrode located in the second through hole is 5 µm or more and 25 µm or less.

19. A method for manufacturing a through electrode substrate on which a semiconductor element is to be mounted, the method comprising:
a step of preparing a glass substrate including a first surface, a second surface located on a side opposite to the first surface, and a first through hole and a second through hole extending from the first surface to the second surface;
a step of forming a through electrode in the first through hole;
a step of forming a resin member in the second through hole; and
a step of forming a wiring layer on the first surface of the glass substrate, wherein
the first through hole includes a first opening that is open at the first surface of the glass substrate and a second opening that is open at the second surface of the glass substrate,
the second through hole includes a third opening that is open at the first surface of the glass substrate and a fourth opening that is open at the second surface of the glass substrate,
the through electrode closes the first through hole between the first opening and the second opening, and
the resin member continuously extends in the second through hole from the third opening to the fourth opening.

20. A method for manufacturing a through electrode substrate on which a semiconductor element is to be mounted, the method comprising:
a step of preparing a glass substrate including a first surface, a second surface located on a side opposite to the first surface, and a first through hole and a second through hole extending from the first surface to the second surface;
a step of forming through electrodes respectively in the first through hole and the second through hole;
a step of forming a resin member at least in the second through hole; and
a step of forming a wiring layer on the first surface of the glass substrate, wherein
the first through hole includes a first opening that is open at the first surface of the glass substrate, a second opening that is open at the second surface of the glass substrate, and a first wall surface located between the first opening and the second opening,
the second through hole includes a third opening that is open at the first surface of the glass substrate, a fourth opening that is open at the second surface of the glass substrate, and a second wall surface located between the third opening and the fourth opening,
the through electrode located in the first through hole extends along the first wall surface from the first opening to the second opening,
the through electrode located in the second through hole extends along the second wall surface from the third opening to the fourth opening,
the resin member is located inside the through electrode in the second through hole and continuously extends from the third opening to the fourth opening,
a hole diameter of the second through hole at the third opening is 50 µm or more and 100 µm or less, and
a thickness of the through electrode located in the second through hole is 5 µm or more and 25 µm or less.

21. A method for manufacturing a semiconductor package, the method comprising:
a step of manufacturing a through electrode substrate using the method for manufacturing a through electrode substrate according to claim 19 or 20; and
a step of mounting a semiconductor element on the through electrode substrate.
